# EUROPÄISCHE PATENTSCHRIFT

(11) **EP 3 915 346 B1**
(45) Veröffentlichungstag und Bekanntmachung des Hinweises auf die Patenterteilung: **29.01.2025**
(21) Anmeldenummer: 20713594.8
(22) Anmeldetag: 20.03.2020
(51) Int. Cl.: H05K 5/00, H05K 5/06, H05K 5/04

(54) **SENDERGEHÄUSE**
TRANSMITTER HOUSING
BOÎTIER DE L'ÉMETTEUR

(30) Priorität: 05.04.2019 DE 202019101972 U
(43) Veröffentlichungstag der Anmeldung: 01.12.2021
(73) Patentinhaber: Haug, Thomas, 75217 Birkenfeld (DE)
(72) Erfinder: Haug, Thomas, 75217 Birkenfeld (DE)
(74) Vertreter: Wacker, Jost Oliver
(86) Internationale Anmeldenummer: PCT/EP2020/057857
(87) Internationale Veröffentlichungsnummer: WO 2020/200851

(56) Entgegenhaltungen:
- WO-A1-2008/055480
- WO-A1-2013/105159
- WO-A1-2014/032423
- DE-A1- 4 125 324
- DE-C1- 19 700 558
- DE-C1- 19 942 826
- DE-U1- 202009 016 312
- DE-U1- 8 533 097
- US-B2- 9 013 036

## Beschreibung

Die Erfindung betrifft ein Sendergehäuse eines Bediengerätes für Geräte und Anlagen, wie insbesondere ferngesteuerte mobile, industrielle oder gewerbliche Geräte und Anlagen, nach dem Oberbegriff des Anspruchs 1. Das Sendergehäuse weist dabei zwei Gehäuseteile auf, die aus einem ersten Profilelement und einem zweiten Profilelement bestehen. Beide Profilelemente weisen jeweils eine Hauptwand auf, an deren beiden Seitenrändern sich eine erste Seitenwand und eine zweite Seitenwand weg erstrecken. Beide Profilelemente sind dabei vorzugsweise aus einem beispielsweise im Stranggussverfahren hergestellten Profillängenmaterial aus Metall durch Ablängen hergestellt. Die Profilelemente sind zu einer Gehäusewandung zusammengesetzt, die eine Aufnahme umschließt. Dabei ist an der Außenseite der Gehäusewandung wenigstens ein Bedienelement, wie beispielsweise ein Joystick, ein Schalter, ein Regler oder ein berührungsempfindlicher Bildschirm angebracht. Zudem ist in der Aufnahme eine Steuerungselektronik aufgenommen. Dabei ist die erste Seitenwand des ersten Profilelementes mit der zweiten Seitenwand des zweiten Profilelementes und die zweite Seitenwand des ersten Profilelementes mit der ersten Seitenwand des zweiten Profilelementes aneinander festgelegt.

Aus der WO2008/055480A1 ist ein Bediengerät für Fernsteuerungen bekannt, bei dem die Gehäusewandung aus zwei abgelängten Profilelementen zusammengesetzt ist. Ein bodenseitiges Profilelement ist dabei als U-Profil ausgebildet, das von dem zweiten als Deckel ausgebildeten Profilelement verschlossen wird. An beiden Enden der so gebildeten Gehäusewandung ist dabei jeweils ein X-förmiges Halteelement angebracht, das aus einem Kunststoffformteil besteht.

DE19700558C1, DE19942826 und DE8533097U1 beschreiben jeweils ein Gehäuse für elektronische Bauteile, das aus zwei rinnenförmigen Halbschalen zusammengesetzt wird. Die Halbschalen können dabei über zwei Nut und Federanordnungen zueinander positioniert werden. Die gegenseitige Festlegung der Halbschalen erfolgt dabei jeweils durch zusätzliche Stirnplatten, die stirnseitig aufgeschraubt werden und dabei in Schraubaufnahmen beider Halbschalen eingreifen.

DE8611965U1 und DE9213671 offenbaren jeweils ein Gehäuse für elektronische Bauteile, das aus zwei Halbschalen zusammengesetzt ist. Beide Schalen weisen dabei an ihren Längsrändern Verzahnungsmittel auf über die Sie mit Gegenverzahnungsmitteln der jeweils anderen Halbschale formschlüssig verbunden werden können.

DE4125324A1 zeigt ein Verfahren zur Herstellung einer Wandung mit einem Sichtfenster. Dabei wird das Sichtfenster bündig mit der Außen- und Innenseite der Wandung in eine Ausnehmung eingespritzt, die in die Wandung eingelassen ist und an ihrem Rand eine umlaufende Nut aufweist. Vor dem Einspritzen des Fenstermaterials wird dabei ein Dichtring in die Nut eingesetzt, durch den ein Schwindprozess des Fenstermaterials nach dessen Einspritzen ausgeglichen werden kann.

US9,013,036B2 und WO2013105159A1 zeigen jeweils ein Gehäuse einer elektronischen Vorrichtung, bei dem zwischen zwei zusammensetzbaren Gehäuseteilen ein in einer Nut aufgenommenes Dichtungselement zusammengepresst wird. Nach gegenseitiger Fixierung der beiden Gehäuseteile, wie beispielsweise mittels Schraubverbindung, dichtet das zusammengepresste Dichtungselement einen Aufnahmeraum nach außen hin ab.

DE202009016312U1 zeigt ein Gehäuse für Steuergeräte mit einer Gehäuserückwand und einer Gehäuseoberfläche, die über eine Schnappverbindung aneinander festlegbar sind. Benachbart zur Schnappverbindung ist dabei eine im verbundenen Zustand von beiden Gehäuseteilen begrenzte Dichtungsaufnahme ausgebildet, in die ein Dichtungsring eingesetzt ist.

WO2014/032423A1 offenbart ein elektronisches Bauteil mit einem wasserdichten zweischaligen Gehäuse, dessen Gehäuseteile über eine Schnappverbindung verbunden sind. Zur Abdichtung des Gehäuses ist dabei ein Dichtring vorgesehen, der an einem Rasthaken der Schnappverbindung befestigt sein kann.

Die Aufgabe der Erfindung ist es, bei einem gattungsgemäßen Sendergehäuse die Herstellung und Montage zu vereinfachen.

Diese Aufgabe wird durch ein Sendergehäuse mit den Merkmalen des Anspruchs 1 gelöst. Dabei ist die erste Seitenwand des ersten Profilelementes mit der zweiten Seitenwand des zweiten Profilelementes und die zweite Seitenwand des ersten Profilelementes mit der ersten Seitenwand des zweiten Profilelementes jeweils unter Zwischenlage eines Dichtungselementes über eine Art Rastanordnung aneinander festgelegt. Dabei werden die jeweils aneinander gehaltenen beiden Seitenwände mittels eines Aufnahmeprofils und eines Eingriffsprofils miteinander verbunden. Dies ermöglicht eine sehr einfache und schnelle Montage der Gehäusewandung durch einfaches Zusammenstecken unter gegenseitiger

Druckbeaufschlagung der Profilelemente. Zudem weisen beide Profilelemente im montierten Zustand eine relativ stabile Verbindung und eine hohe Dichtigkeit auf.

Dabei bildet das Dichtungselement ein alleiniges elastisches Mittel der Rastanordnung, über das die Haltekräfte der verrasteten Verbindung beziehungsweise der Quasiformschluss hergestellt werden kann. Hierdurch werden keine gesondert hergestellten Rastmittel benötigt, wie insbesondere keine elastischen Bereiche innerhalb der Profilelemente. Hierdurch ist eine besonders kostengünstige Herstellung der Gehäusewandung möglich.

Vorteilhafterweise bildet die jeweilige erste Seitenwand der Profilelemente an einem ersten freien Ende ein Aufnahmeprofil, das in Richtung von der Hauptwand weg geöffnet ist, während die jeweilige zweite Seitenwand der Profilelemente an einem zweiten freien Ende ein Eingriffsprofil der Rastanordnung bildet, das in das Aufnahmeprofil des jeweils anderen Profilelementes eingeführt werden kann. Hierdurch können die beiden Profileelemente relativ einfach zusammengesteckt werden, in dem das jeweilige Eingriffsprofil beider Profilelemente in das Aufnahmeprofil des jeweils anderen Profilelementes eingeführt wird, bis beide zueinander beabstandeten Profilanordnungen durch das Zusammenwirken mit dem Dichtungselement aneinander verrasten.

Dabei ist es besonders günstig, wenn sich das jeweilige Eingriffsprofil in Richtung von der Hauptwand weg verjüngt. Durch die verjüngt ausgebildeten beiden Eingriffsprofile kann dabei an beiden Rastanordnungen ein Verkanten beim Zusammenstecken der Profilelemente vermieden werden.

Zudem ist es günstig, wenn am Eingriffsprofil eine Dichtungsaufnahmenut ausgebildet ist, die quer zur Erstreckungsrichtung der zweiten Seitenwand geöffnet ist. Hierdurch ist das jeweilige Dichtungselement beim Ineinanderstecken der beiden Profilelemente sicher am betreffenden Eingriffsprofil gehalten und kann sich quer zu einer Erstreckungsrichtung der zweiten Seitenwand elastisch verformen. Hierdurch kann das Dichtungselement in einfacher Weise als Rastmittel fungieren beziehungsweise einen Quasiformschluss zwischen der Dichtungsaufnahmenut und einem passenden Formschlussgegenmittel des jeweils anderen Profilelementes herstellen.

Dabei ist es günstig, wenn an einer der jeweiligen zweiten Seitenwand zugewandten Innenwand des Aufnahmeprofils ein Rasthakenprofil ausgebildet ist. Hierdurch kann beim Zusammenstecken der beiden Profilelemente beziehungsweise beim Einführen der beiden Eingriffsprofile in die Aufnahmeprofile das in der Dichtungsaufnahmenut gehaltene Dichtungselement vom Rasthakenprofil zusammengedrückt werden. Nach dem Passieren des jeweiligen Rasthakenprofils weitet sich der Querschnitt des Dichtungselementes dann wieder aus, um einen in Trennrichtung der beiden Profilelemente wirkenden Quasiformschluss zu erzeugen. Hierdurch können die beiden Profilelemente im montierten Zustand der Gehäusewandung sicher aneinandergehalten werden.

Vorteilhafterweise bilden beide Profilelemente dabei ein übereinstimmendes U-Profil. Auf diese Weise sind beide Profilelemente als Gleichteile ausgeformt, die insbesondere vom gleichen Profillängenmaterial abgelängt werden können. Hierdurch können die Herstellung und Montage der Gehäusewandung und des Sendergehäuses insgesamt deutlich vereinfacht und die Herstellungskosten vermindert werden.

Vorteilhafterweise weisen beide Profilelemente zudem wenigstens ein durchgehendes Schraubenaufnahmeprofil auf, das beabstandet zur Aufnahme in die Gehäusewandung eingelassen ist. Hierdurch steht das Schraubenaufnahmeprofil auch ohne weitere Bearbeitung direkt nach dem Ablängen der Profilelemente von einem ursprünglichen Profillängenmaterial zur Verfügung. Über diese Schraubenaufnahmeprofile können die Profilelemente nach dem Zusammensetzen zur gemeinsamen Gehäusewandung somit direkt mit zwei stirnseitigen Halteelementen verbunden werden, um die Aufnahme zu schließen.

Ferner ist es günstig, wenn das Schraubenaufnahmeprofil in eine Außenseite der Gehäusewandung eingelassen ist. Auf diese Weise können die Schraubverbindungen zum Festspannen der Halteelemente beabstandet zur Aufnahme hergestellt werden. Insbesondere, wenn die Halteelemente zumindest im Kontaktbereich mit der Gehäusewandung aus einem elastomeren Material, wie Gummi hergestellt sind, kann somit bereits durch die mit den Schraubverbindungen erzeugte Vorspannung eine ausreichende Abdichtung der Aufnahme erzielt werden, so dass gegebenenfalls keine zusätzlichen Abdichtungsmittel benötigt werden.

Es wird darauf hingewiesen, dass alle oben beschriebenen Merkmale des erfindungsgemäßen Gegenstandes untereinander austauschbar beziehungsweise kombinierbar sind, sofern ein Austausch oder eine Kombination derselben aus technischen Gründen nicht ausgeschlossen ist.

In den Figuren ist eine beispielhafte Ausführungsform der Erfindung dargestellt. Es zeigen:
- Figur 1: eine Draufsicht auf ein Bediengerät mit einem erfindungsgemäßen Sendergehäuse,
- Figur 2: eine geschnittene Ansicht durch eine Gehäusewandung in Ebene II-II aus Fig. 1,
- Figur 3: eine geschnittene Ansicht der Gehäusewandung nach Fig. 2 in einem getrennten Zustand
- Figur 4: eine geschnittene Ansicht der Gehäusewandung nach Fig. 2 in einem zusammengesteckten Zustand und
- Figur 5: eine vergrößerte Ansicht des Details V aus Fig. 4.

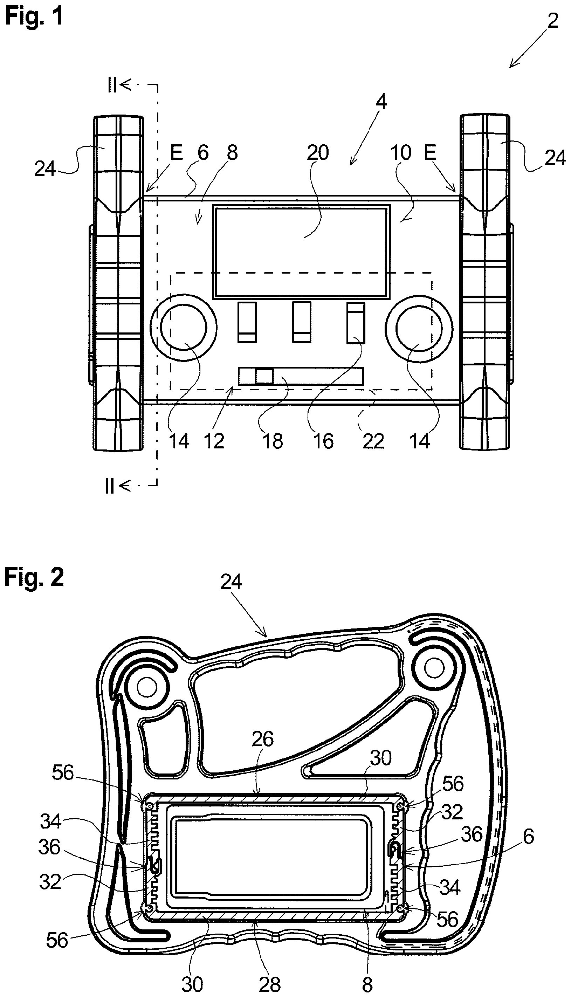

Fig. 1 zeigt ein Bediengerät 2 in Form einer Fernsteuerung für mobile, gewerbliche oder industrielle Geräte und Anlagen, wie insbesondere Hub- oder Transportanlagen. Das Bediengerät 2 weist dabei ein Sendergehäuse 4 mit einer Gehäusewandung 6 auf, die eine Aufnahme 8 umschließt. An einer Außenseite 10 der Gehäusewandung 6 lagern verschiedene Bedienelemente 12, die beispielhaft als Joysticks 14, Schalter 16, Regler 18 und berührungsempfindlicher Bildschirm 20 dargestellt sind. Diese sind zum Betrieb des Bediengerätes 2 mit einer Steuerungselektronik 22 verbunden, die geschützt in der Aufnahme 8 aufgenommen ist.

Wie aus Fig. 1 ferner zu entnehmen ist, ist die Gehäusewandung 6 an ihren Enden E jeweils mit einem Halteelement 24 verbunden, wobei die Halteelemente 24 die Aufnahme 8 verschließen. Die Halteelemente 24 sind hierbei ganz oder teilweise aus einem Elastomermaterial, wie insbesondere Gummi hergestellt.

Wie aus Fig. 2 zu entnehmen ist, ist die Gehäusewandung 6 aus zwei Gehäuseteilen in Form eines ersten Profilelementes 26 und eines zweiten Profilelementes 28 zusammengesetzt. Beide Profilelemente 26, 28 sind gleichteilig U-förmig aus Metall hergestellt und weisen dabei eine Hauptwand 30 auf, an deren Seitenrändern SE sich eine erste Seitenwand 32 und eine zweite Seitenwand 34 weg erstrecken.

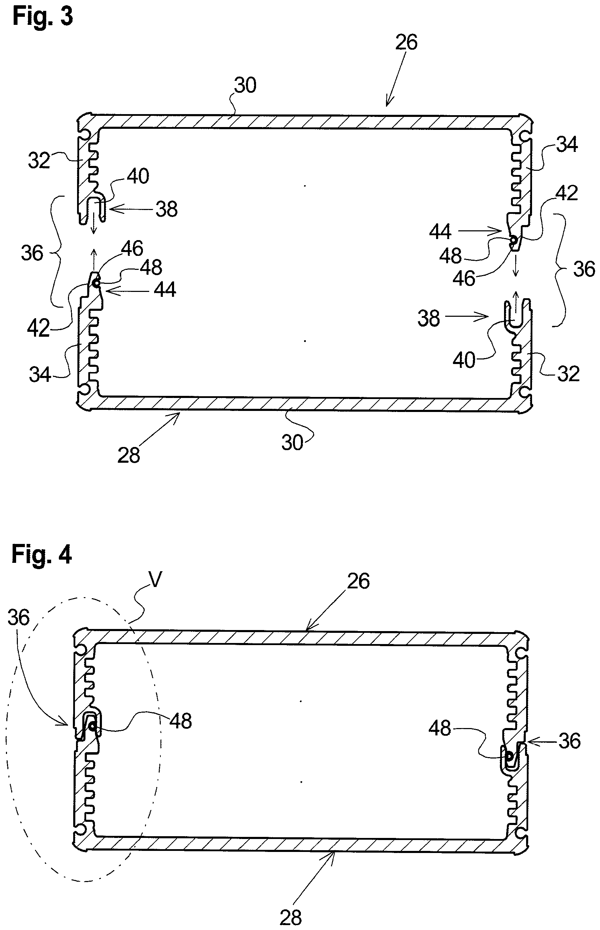

Wie insbesondere aus Fig. 3 zu entnehmen ist, können die Profilelemente 26, 28 über zwei paarweise angeordnete Rastanordnungen 36 zusammengesteckt werden. Hierzu weist jede der Rastanordnungen 36 an einem freien ersten Ende 38 der ersten Seitenwand 32 ein Aufnahmeprofil 40 auf, das in Erstreckungsrichtung der ersten Seitenwand 32 weg von der jeweiligen Hauptwand 30 geöffnet ist. In diese Aufnahmeprofile 40 kann entlang einer parallelen Steckrichtung jeweils ein Eingriffsprofil 42 des jeweils anderen Profilelementes 28, 26 eingeführt werden, das an einem zweiten freien Ende 44 der jeweiligen zweiten Seitenwand 34 ausgebildet ist.

Die Eingriffsprofile 42 verjüngen sich dabei zum zweiten freien Ende 44 hin, um sie beim Zusammenstecken der Profilelemente 26, 28 leichter in die Aufnahmeprofile 40 einführen zu können. Zudem ist in die Eingriffsprofile 42 jeweils eine Dichtungsaufnahmenut 46 eingelassen, die quer zur Erstreckungsrichtung der zweiten Seitenwand 34 geöffnet ist. Die Dichtungsaufnahmenut 46 dient dabei zur Befestigung eines schnurförmigen Dichtungselementes 48, das aus der seitlichen Öffnung herausragt.

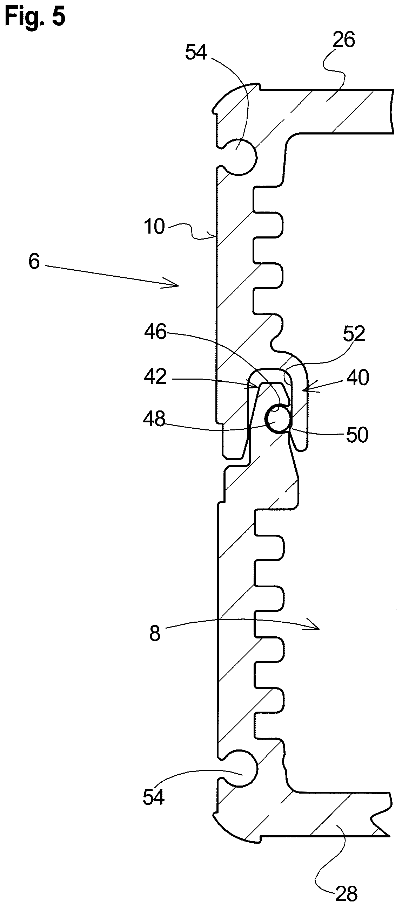

Beim Zusammenstecken der beiden Profilelemente 26, 28 gemäß Fig. 4 dient das Dichtungselement 48 dabei neben seiner Dichtfunktion als alleiniges elastisches Mittel der jeweiligen Rastanordnung 36. Hierzu wirkt das Dichtungselement 48 zusammen mit einem Rasthakenprofil 50, wie es insbesondere aus Fig. 5 zu entnehmen ist. Dieses ist an einer Innenwand 52 des Aufnahmeprofils 40 ausgeformt und ragt von diesem gerade soweit ab, dass es beim Einführen des Eingriffsprofils 42 in das Aufnahmeprofil 40 hinein das jeweilige Dichtungselement 48 verformt und nach dessen Passieren von diesem, beziehungsweise dessen wieder aufgeweitetem Querschnitt hintergriffen wird. Hierdurch wird über das Dichtungselement ein Quasiformschluss zwischen der Dichtungsaufnahmenut 46 des Eingriffsprofils 42 und dem Rasthakenprofil 50 des Aufnahmeprofils 40 hergestellt.

Wie aus Fig. 5 ferner zu entnehmen ist, sind in die Außenseite 10 der Gehäusewandung 6 mehrere durchgehende Schraubenaufnahmeprofile 54 eingelassen. In diesen können beabstandet zur Aufnahme 8 Schrauben zur Herstellung von Schraubverbindungen 56 gemäß Fig. 2 eingedreht werden. Über diese Schraubverbindungen 56 kann somit die über die beiden Rastanordnungen 36 zusammengesteckte Gehäusewandung 6 mit den beiden Halteelementen 24 verspannt werden, um das Sendergehäuse 4 zu bilden.

## Patentansprüche

1. Sendergehäuse (4) eines Bediengerätes (2) für Geräte und Anlagen, wie insbesondere ferngesteuerte mobile industrielle oder gewerbliche Geräte und Anlagen,
mit zwei Gehäuseteilen, die durch ein erstes Profilelement (26) und ein zweites Profilelement (28), die jeweils eine Hauptwand (30) aufweisen, an deren Seitenrändern sich eine erste Seitenwand (32) und eine zweite Seitenwand (34) weg erstrecken, hergestellt und zu einer Gehäusewandung (6) zusammengesetzt sind, die eine Aufnahme (8) umschließt,
wobei an der Außenseite (10) der Gehäusewandung (6) wenigstens ein Bedienelement (12) angebracht und in der Aufnahme (8) eine Steuerungselektronik (22) aufgenommen ist,
wobei die erste Seitenwand (32) des ersten Profilelementes (26) mit der zweiten Seitenwand (34) des zweiten Profilelementes (28) und die zweite Seitenwand (34) des ersten Profilelementes (26) mit der ersten Seitenwand (32) des zweiten Profilelementes (28) jeweils unter Zwischenlage eines Dichtungselementes (48) über eine Rastanordnung (36) aneinander festlegbar sind und das Dichtungselement (48) dabei ein elastisches Mittel der Rastanordnung (36) bildet, wobei die jeweilige erste Seitenwand (32) der Profilelemente (26, 28) an einem ersten freien Ende (38) ein Aufnahmeprofil (40) bildet, das in Richtung von der Hauptwand (30) weg geöffnet ist, während die jeweilige zweite Seitenwand (34) der Profilelemente (26, 28) an einem zweiten freien Ende (44) ein Eingriffsprofil (42) der Rastanordnung (36) bildet, das in das Aufnahmeprofil (40) des jeweils anderen Profilelementes (28, 26) einführbar ist und am Eingriffsprofil (42) eine Dichtungsaufnahmenut (46) ausgebildet ist, die quer zur Erstreckungsrichtung der zweiten Seitenwand (34) geöffnet ist.

2. Sendergehäuse nach Anspruch 1, **dadurch gekennzeichnet, dass** sich das Eingriffsprofil (42) in Richtung von der Hauptwand (30) weg verjüngt.

3. Sendergehäuse nach Anspruch 1 oder 2, **dadurch gekennzeichnet, dass** an einer der jeweiligen zweiten Seitenwand (34) zugewandten Innenwand (52) des Aufnahmeprofils (40) ein Rasthakenprofil (50) in das Aufnahmeprofil (40) ragt.

4. Sendergehäuse nach einem der Ansprüche 1 bis 3, **dadurch gekennzeichnet, dass** beide Profilelemente (26, 28) dabei ein übereinstimmendes U-Profil aufweisen.

5. Sendergehäuse nach einem der Ansprüche 1 bis 4, **dadurch gekennzeichnet, dass** beide Profilelemente (26, 28) wenigstens ein durchgehendes Schraubenaufnahmeprofil (54) aufweisen, das beabstandet zur Aufnahme (8) in die Gehäusewandung (6) eingelassen ist.

6. Sendergehäuse nach Anspruch 5, **dadurch gekennzeichnet, dass** das Schraubenaufnahmeprofil (54) in eine Außenseite (10) der Gehäusewandung (6) eingelassen ist.

## Claims

1. Transmitter housing (4) of an operating device (2) for devices and systems, such as in particular remote-controlled mobile industrial or commercial devices and systems,
comprising two housing parts, which are produced by a first profile element (26) and a second profile element (28), which each have a main wall (30), from the side edges of which a first side wall (32) and a second side wall (34) extend away, and are assembled to form a housing wall (6) which surrounds a receiver (8),
wherein at least one operating element (12) is attached to the outer side (10) of the housing wall (6) and a control electronics (22) is accommodated in the receiver (8),
wherein the first side wall (32) of the first profile element (26) can be fixed to the second side wall (34) of the second profile element (28) and the second side wall (34) of the first profile element (26) can be fixed to the first side wall (32) of the second profile element (28) via a latching element (36) with the interposition of a sealing element (48), and the sealing element (48) forms an elastic means of the latching arrangement (36), wherein the respective first side wall (32) of the profile elements (26, 28) forms at a first free end (38) a receiving profile (40), which is opened in the direction away from the main wall (30), while the respective second side wall (34) of the profile elements (26, 28) forms at a second free end (44) an engagement profile (42) of the latching arrangement (36), which can be introduced into the receiving profile (40) of the respective other profile element (28, 26) and a seal receiving groove (46), which is opened transversely to the direction of extension of the second side wall (34), is formed on the engagement profile (42).

2. Transmitter housing according to claim 1, **characterized in that** the engagement profile (42) tapers away in the direction of the main wall (30).

3. Transmitter housing according to claim 1 or 2, **characterized in that** on an inner wall (52) of the receiving profile (40) facing the respective second side wall (34) a latching hook profile (50) projects into the receiving profile (40).

4. Transmitter housing according to any one of claims 1 to 3, **characterized in that** both profile elements (26, 28) have a matching U-profile.

5. Transmitter housing according to any one of claims 1 to 4, **characterized in that** both profile elements (26, 28) have at least one continuous screw-receiving profile (54), which is let into the housing wall (6) at a distance from the receiver (8).

6. Transmitter housing according to claim 5, **characterized in that** the screw-receiving profile (54) is let into an outer side (10) of the housing wall (6).

## Revendications

1. Boîtier d'émetteur (4) d'un appareil de commande (2) pour des appareils et installations tels qu'en particulier des appareils et installations industriels ou commerciaux mobiles télécommandés,
avec deux parties de boîtier qui sont fabriquées par un premier élément profilé (26) et un second élément profilé (28) qui présentent respectivement une paroi principale (30), à partir des bords latéraux de laquelle une première paroi latérale (32) et une seconde paroi latérale (34) s'étendent, et sont assemblées en une paroi de boîtier (6) qui entoure un logement (8),
dans lequel au moins un élément de commande (12) est monté au niveau du côté extérieur (10) de la paroi de boîtier (6) et une électronique de commande (22) est reçue dans le logement (8),
dans lequel la première paroi latérale (32) du premier élément profilé (26) peut être fixée à la seconde paroi latérale (34) du second élément profilé (28) et la seconde paroi latérale (34) du premier élément profilé (26) peut être fixée à la première paroi latérale (32) du second élément profilé (28) par le biais d'un agencement d'encliquetage (36) en intercalant un élément d'étanchéité (48), et l'élément d'étanchéité (48) forme un moyen élastique de l'agencement d'encliquetage (36), dans lequel la première paroi latérale (32) respective des éléments profilés (26, 28) forme au niveau d'une première extrémité libre (38) un profilé de réception (40) qui est ouvert en s'éloignant de la paroi principale (30), tandis que la seconde paroi latérale (34) respective des éléments profilés (26, 28) forme au niveau d'une seconde extrémité libre (44) un profilé de prise (42) de l'agencement d'encliquetage (36) qui peut être introduit dans le profilé de réception (40) de l'autre élément profilé respectif (28, 26) et une rainure de réception d'étanchéité (46) est formée au niveau du profilé de prise (42), rainure qui est ouverte transversalement au sens d'étendue de la seconde paroi latérale (34).

2. Boîtier d'émetteur selon la revendication 1, **caractérisé en ce que** le profilé de prise (42) se rétrécit à partir de la paroi principale (30).

3. Boîtier d'émetteur selon la revendication 1 ou 2, **caractérisé en ce qu'**un profilé de crochet d'encliquetage (50) pénètre dans le profilé de réception (40) au niveau d'une paroi intérieure (52) tournée vers la seconde paroi latérale (34) respective du profilé de réception (40).

4. Boîtier d'émetteur selon l'une quelconque des revendications 1 à 3, **caractérisé en ce que** les deux éléments profilés (26, 28) présentent un profilé en U concordant.

5. Boîtier d'émetteur selon l'une quelconque des revendications 1 à 4, **caractérisé en ce que** les deux éléments profilés (26, 28) présentent au moins un profilé de réception de vis (54) continu qui est encastré à distance du logement (8).

6. Boîtier d'émetteur selon la revendication 5, **caractérisé en ce que** le profilé de réception de vis (54) est encastré dans un côté extérieur (10) de la paroi de boîtier (6).
